# FASCICULE DE BREVET EUROPEEN

(11) **EP 0 422 554 B1**
(45) Date de publication et mention de la délivrance du brevet: **02.02.1994**
(21) Numéro de dépôt: 90119251.8
(22) Date de dépôt: 08.10.1990
(51) Int. Cl.: H01L 25/07, H01L 23/538

(54) **Montage en cascade d'étages de transistors en parallèle réalisé en circuit hybride**
Kaskaden-Montierung von parallelgeschalteten Transistoren realisiert in Hybridschaltungstechnologie
Cascade assembly of transistors in parallel realised in hybrid circuit technology

(30) Priorité: 11.10.1989 FR 8913277
(43) Date de publication de la demande: 17.04.1991
(73) Titulaire: GEC ALSTHOM SA, 75116 Paris (FR)
(72) Inventeur: Chave, Jacques, F-69003 Lyon (FR)
(74) Mandataire: Weinmiller, Jürgen

(56) Documents cités:
- EP-A- 0 265 833
- EP-A- 0 277 546
- FR-A- 2 620 862
- GB-A- 2 135 824
- US-E- 27 730

## Description

La présente invention concerne un montage en cascade d'étages de transistors en parallèle réalisé en circuit hybride.

On rappelle qu'un circuit hybride est un assemblage de composants électroniques sur un support appelé substrat, sur lequel est sérigraphié un réseau de pistes conductrices aboutissant à des plots de connexion desdits composants, ladite connexion étant effectuée dans le cas de composants actifs au moyen de fils conducteurs de très faible section (connus sous le terme anglo-saxon de "bondings") raccordant les plots de connexion des pastilles de semi-conducteur formant lesdits composants actifs aux plots de connexion correspondants du substrat du circuit hybride.

GB-A-2 135 824 concerne un montage de transistors en parallèle réalisé en circuit hybride, les transistors étant disposés sur des pistes conductrices suivant une matrice.

Pour un montage donné il existe en général une grande variété de schémas d'implantation possibles de ces éléments.

La présente invention a pour objet un schéma d'implantation particulier, destiné à des montages en cascade d'étages de transitors en parallèle, tels que les montages dits "Darlington", ou "MOS-BIP" (association de transistors de type MOS et de type bipolaire), très utilisés notamment en électronique de puissance ou dans les systèmes de conversion d'énergie.

Le schéma d'implantation suivant l'invention permet plus particulièrement d'obtenir un meilleur équilibrage du courant entre la sortie d'un étage dit de commande et l'entrée d'un étage dit commandé, d'où une optimisation du fonctionnement de ce montage et une réduction des risques de détérioration des composants électroniques qui le constituent.

L'invention a pour objet, un montage en cascade d'étages de transistors en parallèle réalisé en circuit hybride, ledit montage comportant un étage de commande à n transistors et un étage commandé à m.n transistors, ces différents transistors se présentant sous forme de différentes pastilles de semi-conducteur lesdites pastilles de semi-conducteur étant disposées suivant une matrice à n colonnes et m+1 lignes, à raison d'un transistor de l'étage de commande par colonne pour m transistors de l'étage commandé, les différentes colonnes étant réalisées sur différentes pistes conductrices d'un premier type disposées sur le substrat et reliées entre elles et étant séparées alternativement par des pistes conductrices d'un deuxième et d'un troisième type, disposées sur le substrat et reliées entre elles, chaque pastille de semi-conducteur étant munie de plots de connexion d'un premier type localisés sur la face placée en regard du substrat du circuit hybride et d'un deuxième et d'un troisième type localisés sur une autre face, lesdites pistes conductrices du premier type étant placées au contact des plots de connexion du premier type, et lesdites pistes du deuxième et du troisième type étant connectées aux plots de connexion des deuxième et troisième types par l'intermédiaire de fils conducteurs, et ledit montage étant tel que les plots de connexion du premier type des transistors de l'étage de commande sont connectés aux plots de connexion du premier type des transistors de l'étage commandé, que les plots de connexion du deuxième type des transistors de l'étage de commande, formant la sortie de cet étage, sont connectés aux plots de connexion du deuxième type des transistors de l'étage commandé, formant l'entrée de cet étage, et que les plots de connexion du troisième type des transistors de l'étage de commande sont connectés entre eux, ainsi que les plots de connexion du troisième type des transistors de l'étage commandé.

D'autres objets et caractéristiques de la présente invention apparaîtront plus clairement à la lecture de la description suivante d'un exemple de réalisation, faite en relation avec les dessins ci-annexés dans lesquels:
- la figure 1 rappelle le schéma électrique d'un montage dit "MOS-BIP".
- la figure 2 est un schéma d'implantation, suivant l'invention, en circuit hybride, du montage "MOS-BIP" représenté sur la figure 1.

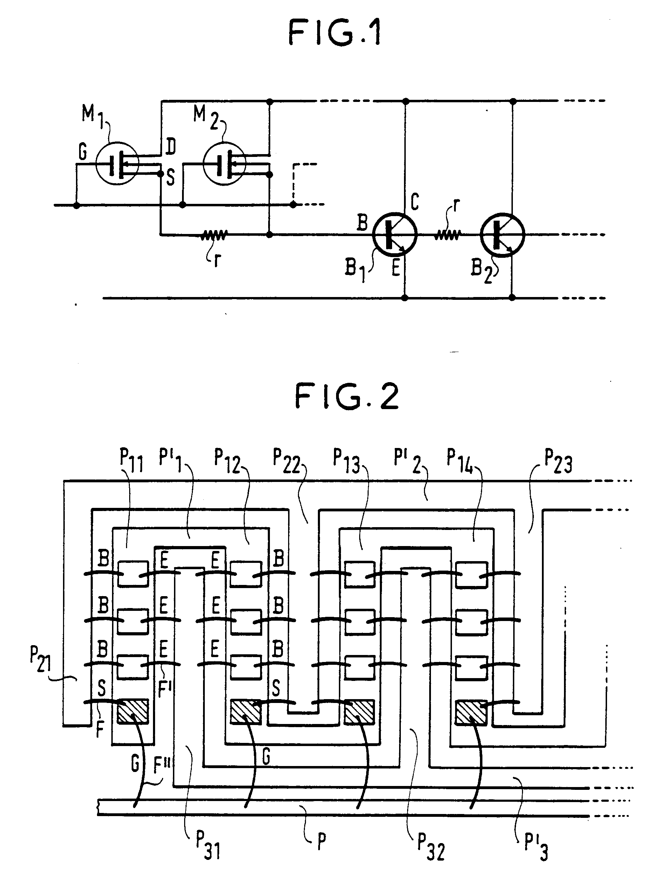

Le montage "MOS-BIP" représenté sur la figure 1 est un montage en cascade de deux étages de transistors en parallèle, dont un étage dit de commande formé de "n" transistors MOS M₁, M₂, ....etc en parallèle, et un étage dit commandé formé de "m.n" transistors bipolaires B1, B2 etc en parallèle.

La sortie de l'étage de commande, constituée par la réunion des sources S des différents transistors MOS est reliée à l'entrée de l'étage commandé, formé par la réunion des bases B des différents transistors bipolaires.

Les grilles G des transistors MOS sont par ailleurs reliées entre elles, ainsi que les émetteurs E des transistors bipolaires, et les drains D réunis des transistors MOS sont reliés aux collecteurs C réunis des transistors bipolaires.

Pour la réalisation de ce montage en circuit hybride, ces transistors se présentent sous la forme de pastilles de semi-conducteur de forme parallèlépipédique, munies sur leurs faces arrière et avant, constituées respectivement par la face placée en regard du substrat du circuit hybride, et par la face opposée à celle-ci, de plots de connexion correspondant aux différentes électrodes de ces transistors.

Pour un transistor MOS, le plot d'accès au drain est placé sur la face arrière et les plots d'accès à la grille et à la source sont placés sur la face avant. Pour un transistor bipolaire, le plot d'accès au collecteur est placé sur la face arrière et les plots d'accès à la base et à l'émetteur sont placés sur la face avant.

Sur le schéma d'implantation représenté sur la figure 2, ces pastilles de semi-conducteur sont organisées en matrice à "n" colonnes et "m+1" lignes, à raison d'un transistor MOS par colonne pour trois transistors bipolaires (la figure 2 illustrant en effet à titre d'exemple le cas m=3), les transistors MOS étant reconnaissables par leur face avant hâchurée et les transistors bipolaires par leur face avant non hâchurée.

Les drains des transistors MOS des différentes colonnes se trouvent reliés aux collecteurs des transistors bipolaires par montage de ces transistors sur différentes pistes conductrices P₁₁, P₁₂,...etc reliées entre elles par des pistes conductrices transversales telles que P′₁.

Les différentes colonnes de transistors, ainsi disposées sur ces pistes conductrices P₁₁, P₁₂....etc, sont par ailleurs séparées alternativement par des pistes conductrices P₂₁, P₂₂, P₂₃... d'une part et P₃₁, P₃₂......d'autre part, permettant respectivement de connecter la base des transistors bipolaires d'une colonne à la source du transistor MOS de cette colonne, par l'intermédiaire de fils conducteurs tels que F, et les émetteurs des transistors bipolaires d'une colonne entre eux, par l'intermédiaire de fils conducteurs tels que F'.

Les pistes conductrices P₂₁, P₂₂, P₂₃..... sont reliées entre elle par des pistes conductrices transversales telles que P'₂ et les pistes conductrices P₃₁, P₃₂....par des pistes conductrices transversales telles que P'₃.

Pour une meilleure compacité de ce schéma d'implantation, les pistes conductrices transversales telles que P′₁, P′₂, et P′₃ sont avantageusement situées de part et d'autre du motif ainsi obtenu.

Les grilles des différents transistors MOS sont par ailleurs reliées entre elles par l'intermédiaire de fils conducteurs tels que F'' reliés à une même piste conductrice P, placée avantageusement de façon transversale.

Afin d'équilibrer le passage du courant entre la source des transistors MOS et la base des transistors bipolaires, les fils conducteurs, respectivement tels que F, F' et F'', sont de longueur égale et les plus courts possible. Ceci permet de réduire au minimum les résistances de liaison, référencées "r" sur la figure 1, entre transistors MOS d'une part et transistors bipolaires d'autre part, et également de réduire les boucles de courant, et donc les selfs parasites.

## Revendications

1. Montage en cascade d'étages de transistors en parallèle réalisé en circuit hybride, ledit montage comportant un étage de commande à n transistors et un étage commandé à m.n transistors, ces différents transistors se présentant sous forme de différentes pastilles de semi-conducteur lesdites pastilles de semi-conducteur étant disposées suivant une matrice à n colonnes et m+1 lignes, à raison d'un transistor de l'étage de commande par colonne pour m transistors de l'étage commandé, les différentes colonnes étant réalisées sur différentes pistes conductrices d'un premier type disposées sur le substrat et reliées entre elles, et étant séparées alternativement par des pistes conductrices d'un deuxième et d'un troisième type disposées sur le substrat et reliées entre elles, chaque pastille de semi-conducteur étant munie de plots de connexion d'un premier type localisés sur leur face placée en regard du substrat du circuit hybride et d'un deuxième et d'un troisième type localisés sur une autre face, lesdites pistes conductrices du premier type étant placées au contact des plots de connexion du premier type, et lesdites pistes, du deuxième et du troisième type étant connectées aux plots de connexion des deuxième et troisième types par l'intermédiaire de fils conducteurs,et ledit montage étant tel que les plots de connexion du premier type des transistors de l'étage de commande sont connectés aux plots de connexion du premier type des transistors de l'étage commandé, que les plots de connexion du deuxième type des transistors de l'étage de commande, formant la sortie de cet étage, sont connectés aux plots de connexion du deuxième type des transistors de l'étage commandé, formant l'entrée de cet étage, et que les plots de connexion du troisième type des transistors de l'étage de commande sont connectés entre eux, ainsi que les plots de connexion du troisième type des transistors de l'étage commandé.

2. Montage suivant la revendication 1, caractérisé en ce que la longueur des fils conducteurs raccordant les plots de connexion des pastilles de semi-conducteur à un même type de piste conductrice est identique.

3. Montage suivant l'une des revendications 1 et 2, caractérisé en ce que lesdites pistes conductrices sont reliées entre elles par des pistes conductrices disposées transversalement.

4. Montage suivant la revendication 3, caractérisé en ce que lesdites pistes conductrices disposées transversalement sont disposées de part et d'autre du motif formé par les pistes conductrices sur lesquelles sont disposées les colonnes de pastilles de semi-conducteur, ou les séparant.

## Patentansprüche

1. Hybridschaltung mit einer Kaskadenanordnung von Stufen mit parallelen Transistoren, wobei die Schaltung eine Steuerstufe mit n Transistoren und eine gesteuerte Stufe mit m.n Transistoren aufweist und die verschiedenen Transistoren als einzelne Halbleiterchips ausgebildet sind, die matrixartig in n Spalten und m+1 Zeilen angeordnet sind, und zwar mit einem Transistor der Steuerstufe und m Transistoren der gesteuerten Stufe in jeder Spalte, wobei die verschiedenen Spalten auf verschiedenen miteinander verbundenen und auf dem Substrat angeordneten Leitbahnen eines ersten Typs ausgebildet sind und abwechselnd durch Leitbahnen eines zweiten und eines dritten Typs voneinander getrennt sind, die sich ebenfalls auf dem Substrat befinden und jeweils miteinander verbunden sind, wobei jedes Halbleiterchip mit Anschlußpunkten eines ersten Typs auf ihrer dem Substrat der Hybridschaltung zugewandten Seite und Anschlußpunkte eines zweiten und eines dritten Typs besitzt, die auf einer anderen Seite liegen, wobei die Leitbahnen des ersten Typs mit den Anschlußpunkten des ersten Typs in Kontakt stehen und die Leitbahnen des zweiten und des dritten Typs mit den Anschlußpunkten des zweiten bzw. des dritten Typs über Leiterdrähte verbunden sind und wobei die Anschlußpunkte des ersten Typs der Steuerstufen-Transistoren an die Anschlußpunkte des ersten Typs der Transistoren der gesteuerten Stufe und die Anschlußpunkte des zweiten Typs der Steuerstufen-Transistoren, die den Ausgang dieser Stufe bilden, an die Anschlußpunkte des zweiten Typs der Transistoren der gesteuerten Stufe, die den Eingang dieser Stufe bilden, angeschlossen sind, während die Anschlußpunkte des dritten Typs der Steuerstufen-Transistoren ebenso wie die Anschlußpunkte des dritten Typs der Transistoren der gesteuerten Stufe jeweils miteinander verbunden sind.

2. Schaltung nach Anspruch 1, dadurch gekennzeichnet, daß die Länge der Leiterdrähte, die die Anschlußpunkte der Halbleiterchips an einen jeweiligen Typ von Leitbahnen anschließen, konstant ist.

3. Schaltung nach einem der Ansprüche 1 und 2, dadurch gekennzeichnet, daß die Leitbahnen miteinander über quer verlaufende Leitbahnen verbunden sind.

4. Schaltung nach Anspruch 3, dadurch gekennzeichnet, daß die quer verlaufenden Leitbahnen zu beiden Seiten des von den Leitbahnen gebildeten Motivs angeordnet sind, auf denen die Spalten von Halbleiterchips angeordnet sind, oder sie trennen.

## Claims

1. A hybrid circuit comprising a cascade connection of parallel-transistor stages, the circuit comprising a control stage having n transistors and a controlled stage having m.n transistors, these various transistors being in the form of respective semiconductor chips, said semiconductor chips being disposed in a matrix of n columns by m+1 rows, there being one control stage transistor per column for m controlled stage transistors, the various columns being formed on different interconnected conductor tracks of a first type disposed on the substrate, and being separated alternately by interconnected conductor tracks of a second type and of a third type, which tracks are disposed on the substrate, each semiconductor chip being provided with connection tabs of a first type located on the face facing the substrate of the hybrid circuit and connection tabs of a second type and of a third type located on another face, said conductor tracks of the first type being placed in contact with the connection tabs of the first type, and said conductor tracks of the second type and of the third type being_connected to the connection tabs of the second and third types via conductor wires, said circuit being such that the connection tabs of the first type of the transistors in the control stage are connected to the connection tabs of the first type of the transistors in the controlled stage, in that the connection tabs of the second type of the transistors in the control stage and constituting the output of the control stage are connected to the connection tabs of the second type of the transistors of the controlled stage, constituting the input of the controlled stage, and in that the connection tabs of the third type of the transistors in the control stage are interconnected, as are the connection tabs of the third type of the transistors in the controlled stage.

2. A circuit according to claim 1, characterized in that the conductor wires connecting the connection tabs of the semiconductor chips to a conductor track of the same type are identical.

3. A circuit according to claim 1 or 2, characterized in that said conductor tracks are interconnected by conductor tracks disposed transversely.

4. A circuit according to claim 3, characterized in that said conductor tracks disposed transversely are disposed on either side of the pattern constituted by the conductor tracks on which the columns of semiconductor chips are disposed and the intervening columns of conductor tracks.
